(19) Europäisches Patentamt
European Patent Office
Office européen des brevets

(11) **EP 3 319 112 A1**

(12) **EUROPÄISCHE PATENTANMELDUNG**

(43) Veröffentlichungstag:
**09.05.2018 Patentblatt 2018/19**

(51) Int Cl.:
*H01J 37/305* (2006.01)     *H01J 37/04* (2006.01)
*H01J 37/08* (2006.01)

(21) Anmeldenummer: **16197531.3**

(22) Anmeldetag: **07.11.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Meyer Burger (Germany) AG**
**09337 Hohenstein-Ernstthal (DE)**

(72) Erfinder:
• **Allenstein, Frank**
 **09116 Chemnitz (DE)**
• **Luca, Alfonz**
 **09126 Chemnitz (DE)**
• **Stober, Rico**
 **09119 Chemnitz (DE)**

(74) Vertreter: **Kailuweit & Uhlemann Patentanwälte**
**Partnerschaft mbB**
**Bamberger Straße 49**
**01187 Dresden (DE)**

(54) **VORRICHTUNG ZUR EXTRAKTION VON ELEKTRISCHEN LADUNGSTRÄGERN AUS EINEM LADUNGSTRÄGERERZEUGUNGSRAUM**

(57)    Die Erfindung betrifft eine Vorrichtung (1) zur Extraktion von elektrischen Ladungsträgern aus einem Ladungsträgererzeugungsraum (2) mit einer ersten Elektrode (11), die mindestens eine Öffnung (111) zum Durchtritt der elektrischen Ladungsträger enthält, wobei die Öffnung in einer ersten Oberfläche (112) der ersten Elektrode einen ersten Flächeninhalt (A1) hat, der kleiner ist als ein zweiter Flächeninhalt (A2) der Öffnung in einer zweiten Oberfläche (113) der ersten Elektrode. Die erste Oberfläche ist dabei die dem Ladungsträgererzeugungsraum abgewandte Oberfläche der ersten Elektrode und die zweite Oberfläche ist die dem Ladungsträgererzeugungsraum zugewandte Oberfläche der ersten Elektrode. Die erste Elektrode ist mindestens in lateralen Bereichen angrenzend an die mindestens eine Öffnung elektrisch leitfähig und von allen Elektroden der Vorrichtung, die während des Betriebes der Vorrichtung der Beschleunigung von elektrischen Ladungsträgern aus dem Ladungsträgererzeugungsraum in Teilchenaustrittsrichtung dienen, diejenige Elektrode, die den geringsten Abstand zum Ladungsträgererzeugungsraum in Teilchenaustrittsrichtung aufweist.

Fig. 2

EP 3 319 112 A1

## EP 3 319 112 A1

**Beschreibung**

Die Erfindung betrifft eine Vorrichtung zur Extraktion von elektrischen Ladungsträgern aus einem Ladungsträgererzeugungsraum, bei der die Ablagerung eines Materials, das von der Oberfläche eines mittels der elektrischen Ladungsträger bearbeiteten Substrats rückgestreut wird, in bestimmten Bereichen geringer ist als bei entsprechenden Vorrichtungen aus dem Stand der Technik und die damit eine längere Betriebsdauer ermöglicht.

Gerichtete Teilchenstrahlen aus elektrischen Ladungsträgern, bspw. Ionenstrahlen oder Elektronenstrahlen, werden in einer Teilchenstrahlquelle durch die Extraktion von elektrischen Ladungsträgern, also Ionen oder Elektronen, aus einem Ladungsträgererzeugungsraum, bspw. einem Plasma, erzeugt, wobei die Teilchen sich nach Verlassen der Teilchenstrahlquelle gerichtet und strahlförmig im Raum in eine Teilchenaustrittsrichtung bewegen. Dazu werden eine oder mehrere Vorrichtungen zur Extraktion von elektrischen Ladungsträgern eingesetzt, die jeweils aus einer oder mehreren Elektroden bestehen und die Teilchen aus dem Ladungsträgererzeugungsraum extrahieren und beschleunigen sowie ggf. in eine vorgegebene Richtung ablenken. Dabei weist jede Elektrode mindestens eine Öffnung auf, durch die die zu extrahierenden Ladungsträger (Teilchen) hindurchtreten. Insbesondere zur Erzeugung von Breitstrahlen mit einer Strahlbreite von bis zu 1 m, weisen die Elektroden eine Gitterform auf, so dass jede Elektrode ein mechanischer (physischer oder materieller) Verbund einer Mehrzahl von Öffnungen, durch die die Ladungsträger hindurchtreten können, ist. Solche Elektroden sind als Gitterelektroden bekannt. Die dabei entstehenden einzelnen Teilchenteilstrahlen können ggf. auch zueinander ausgerichtet werden. Eine Elektrode ist dabei ein (im Allgemeinen) flächenförmiges Bauteil, dessen laterale Abmessungen um ein Vielfaches größer als seine Dicke, d.h. seine Ausdehnung in Teilchenaustrittsrichtung, sind und das mindestens eine Öffnung aufweist, die sich in Dickenrichtung über die gesamte Dicke des Bauteils erstreckt und einen Durchtritt von Ladungsträgern durch das Bauteil ermöglicht. Die mindestens eine Öffnung ist gemäß dem Stand der Technik eine Öffnung, die über die gesamte Dicke des Bauteils annähernd die gleiche Größe, d.h. den gleichen Flächeninhalt in allen Dickenebenen senkrecht zur Teilchenaustrittsrichtung, hat. In der Regel ist die Öffnung als zylindrisches Loch in der Elektrode ausgebildet. Die Elektrode weist zumindest in einigen Bereichen ein elektrisch leitfähiges Material auf, das mit einem Potential beaufschlagt werden kann, so dass die Ladungsträger extrahiert und beschleunigt oder der oder die Teilchenteilstrahlen gesperrt werden können. Üblicherweise ist eine solche Elektrode aus einem elektrisch leitfähigen Material, bspw. Graphit, ausgebildet.

In einer Vorrichtung zur Extraktion von elektrischen Ladungsträgern, wie sie bspw. in der US 4,523,971 B, der DE 10 2004 002 508 A1 oder der US 7,285,788 B2 beschrieben werden, sind üblicherweise mehrere Elektroden in Teilchenaustrittsrichtung nacheinander in voneinander beabstandeten Lagen angeordnet, wobei die Öffnungen der einzelnen Elektroden zueinander korrespondieren, so dass bei einer entsprechenden Potentialbeaufschlagung der einzelnen Elektroden Ladungsträger als Teilchenteilstrahlen durch die Öffnungen der Elektroden hindurchtreten können. Das heißt, die Teilchen, die durch eine Anordnung miteinander korrespondierender Öffnungen in den Elektroden hindurchtreten, bilden einen Teilstrahl eines Teilchengesamtstrahls, der von der Vorrichtung zur Extraktion von elektrischen Ladungsträgern erzeugt wird. Diese Teilchenteilstrahlen werden beamlets genannt. Oftmals werden mindestens drei Elektroden eingesetzt, die als Plasma-, Screen- oder Beamelektrode, als Beschleunigungs- oder Accelerationselektrode und als Masseelektrode entsprechend ihrer Funktion bezeichnet werden. Jedoch können auch weitere Elektroden in der Vorrichtung zur Extraktion von elektrischen Ladungsträgern angeordnet werden, um bspw. den erzeugten Teilchengesamtstrahl bezüglich seiner Austrittsrichtung zu beeinflussen.

Teilchenstrahlen werden bspw. in Ionenstrahl- oder Elektronenstrahlbearbeitungsanlagen unter anderem zur Bearbeitung von Oberflächen eines Substrates eingesetzt. Dabei können die Topographie der Oberfläche oder andere physikalische oder chemische Eigenschaften der Oberfläche, wie bspw. hygroskopische Eigenschaften, durch das Auftreffen der Teilchen auf der Oberfläche verändert werden. Insbesondere beim Sputtern und Ionenstrahlätzen wird durch die auf die Oberfläche des Substrates auftreffenden Teilchen Material von der Oberfläche des Substrates abgetragen, wobei sich die abgetragenen Materialteilchen auch in Richtung der Teilchenstrahlquelle bewegen und sich auf den Elektroden ablagern können. Insbesondere wenn sich isolierende oder halbleitende Materialien auf den Elektroden ablagern und/oder wenn die abgelagerten Teilchen nur schlecht haftende Schichten bilden, die mit der Zeit abplatzen, kommt es zu elektrischen Überschlägen, sogenannten Bogen- oder Arc-Entladungen, zwischen Elektroden, die eine hohe Potentialdifferenz aufweisen. Durch diese Entladungen wird die Potentialdifferenz zwischen den Elektroden aufgehoben und die Extraktion der elektrischen Ladungsträger erheblich gestört. Da die Entladungen nicht steuerbar sind, wird die Standzeit der Vorrichtung zur Extraktion von elektrischen Ladungsträgem drastisch reduziert, bspw. auf bis zu 10 % der üblichen Standzeit.

Es ist daher Aufgabe der Erfindung, die Entstehung von Bogenentladungen zu erschweren und damit die Standzeit der Vorrichtung zur Extraktion von elektrischen Ladungsträgern deutlich zu erhöhen.

Diese Aufgabe wird gelöst durch eine Vorrichtung zur Extraktion von elektrischen Ladungsträgern aus einem Ladungsträgererzeugungsraum gemäß Anspruch 1. Bevorzugte Weiterentwicklungen und Ausführungsformen finden sich in den rückbezogenen Unteransprüchen.

Die erfindungsgemäß optimierte Vorrichtung zur Extraktion von elektrischen Ladungsträgern aus einem Ladungsträgererzeugungsraum enthält eine erste Elektrode mit mindestens einer Öffnung, durch die die elektrischen Ladungsträger in Teilchenaustrittsrichtung hindurchtreten können. Die erste Elektrode ist mindestens in lateralen Bereichen angrenzend an die mindestens eine Öffnung elektrisch leitfähig und von anderen Elektroden, die in Teilchenaustrittsrichtung ggf. vor oder hinter ihr angeordnet sind, elektrisch isoliert Die erste Elektrode ist die in Teilchenaustrittsrichtung erste Elektrode, die auf diejenige Elektrode der Vorrichtung folgt, bei der während des Betriebes der Vorrichtung die Extraktion von elektrischen Ladungsträgern an der Randschicht des Ladungsträgererzeugungsraums, bspw. an der Plasmarandschicht, erfolgt. Das heißt, wenn die Vorrichtung zur Extraktion von elektrischen Ladungsträgern mehrere Elektroden enthält, die während des Betriebes mit einem Potential beaufschlagt werden, das eine Beschleunigung der Ladungsträgern aus dem Ladungsträgererzeugungsraum in Teilchenaustrittsrichtung ermöglicht, so ist diejenige dieser Elektroden, die mit dem kleinsten Abstand zum Ladungsträgererzeugungsraum angeordnet ist, die erste Elektrode im Sinne der vorliegenden Anmeldung. Die mindestens eine Öffnung der ersten Elektrode hat einen ersten Flächeninhalt in einer ersten Oberfläche der ersten Elektrode, der kleiner ist als ein zweiter Flächeninhalt der Öffnung in einer zweiten Oberfläche der ersten Elektrode. Die erste Oberfläche ist dabei die dem Ladungsträgererzeugungsraum abgewandte Oberfläche der ersten Elektrode und die zweite Oberfläche ist die dem Ladungsträgererzeugungsraum zugewandte Oberfläche der ersten Elektrode.

Vorzugsweise weist die mindestens eine Öffnung in jeder Querschnittsebene durch die Öffnung einen ersten Punkt auf der Begrenzungslinie der Öffnung auf der ersten Oberfläche der ersten Elektrode auf. Eine Querschnittsebene ist dabei eine Ebene, die sich entlang der Richtung der durch die Öffnung hindurchtretenden elektrischen Ladungsträger (Teilchenaustrittsrichtung) erstreckt und die Öffnung schneidet und durch den Mittelpunkt der Öffnung in der ersten Oberfläche verläuft, so dass die Innenseite der Öffnung in der Querschnittsebene durch zwei Innenseitenkurven beschrieben wird. Unter einer "Innenseitenkurve" wird der Verlauf der Innenseite der Öffnung in der Querschnittsebene von der ersten Oberfläche der ersten Elektrode bis zur zweiten Oberfläche der ersten Elektrode auf einer der beiden Seiten der Öffnung in der Querschnittsebene verstanden. Der Mittelpunkt der Öffnung in der ersten Oberfläche ist dabei der geometrische Schwerpunkt der Öffnung. Eine erste Innenseitenkurve erstreckt sich vom ersten Punkt bis zur zweiten Oberfläche der ersten Elektrode. Der erste Punkt weist einen ersten Abstand zum Mittelpunkt der Öffnung in der ersten Oberfläche auf, während alle anderen Punkte auf der mit dem ersten Punkt in der Querschnittsebene verbundenen ersten Innenseitenkurve dieser Öffnung zu einer Mittelpunktnormalen einen Abstand zu der Mittelpunktnormalen aufweisen, der gleich oder größer als der erste Abstand ist. Damit ist der erste Abstand jeweils der kleinste Abstand aller Punkte auf der mit dem ersten Punkt in der Querschnittsebene verbundenen ersten Innenseitenkurve dieser Öffnung zu der Mittelpunktnormalen. Die Mittelpunktnormale ist die Normale auf die erste Oberfläche oder auf die Tangentialebene an die erste Oberfläche im Mittelpunkt der Öffnung in der ersten Oberfläche. Mindestens ein Teil aller Punkte der ersten Innenseitenkurve weist einen Abstand, der größer als der erste Abstand ist, auf. Das gleiche gilt für die zweite Innenseitenkurve der Öffnung in der Querschnittsebene. Vorzugsweise weisen mindestens 50 % aller Punkte der Innenseitenkurven, besonders bevorzugt 90 % aller Punkte der Innenseitenkurven, und ganz besonders bevorzugt alle Punkte der Innenseitenkurven außer dem jeweils ersten Punkt, einen größeren Abstand zur Mittelpunktnormalen als den ersten Abstand auf. Das heißt, die Mehrzahl aller weiteren Punkte einer Innenseitenkurve in der Querschnittsebene haben einen Abstand zur Mittelpunktnormalen, der größer als der erste Abstand ist. Damit wird sichergestellt, dass die von einem mit den elektrischen Ladungsträgern bearbeiteten Substrat zurückgestreuten Materialteilchen nicht oder nur in verringertem Maße an die Innenseiten der mindestens einen Öffnung der ersten Elektrode gelangen und sich dort ablagern können. Es wird damit eine, zumindest teilweise, Abschattung der Innenseiten der mindestens einen Öffnung gegenüber den von der Substratoberfläche zurückgestreuten Materialteilchen erreicht. Dieser Effekt ist bereits bei einem kleinen Anteil von Punkten einer Innenseitenkurve, die einen größeren Abstand zur Mittelpunktnormalen als den ersten Abstand aufweisen, gegeben, wird jedoch umso größer, je größer der Anteil dieser Punkte an allen Punkten einer Innenseitenkurve ist.

Die mindestens eine Öffnung weist in einer Ebene, die senkrecht zur Teilchenaustrittsrichtung verläuft, eine beliebige Form auf. So kann die Form kreisrund, oval, elliptisch, drei- oder mehreckig oder unregelmäßig und für unterschiedliche Öffnungen verschieden sein. Vorzugsweise ändert sich die Form einer Öffnung über deren Ausdehnung von der ersten zur zweiten Oberfläche der ersten Elektrode nicht wesentlich. Dabei bedeutet "nicht wesentlich" bspw., dass eine elliptische Form der Öffnung zwar erhalten, das Verhältnis der Längen von Haupt- und Nebenachse aber über die Ausdehnung der Öffnung hinweg variieren kann.

Enthält die Vorrichtung zur Extraktion von Ladungsträgern mehrere Elektroden, so weisen alle Elektroden zueinander korrespondierende Öffnungen auf. Unter "korrespondierenden Öffnungen" in verschiedenen Elektroden werden im Sinne der Anmeldung Öffnungen verstanden, die in unterschiedlichen Lagen senkrecht zur Teilchenaustrittsrichtung angeordnet sind und bei einer entsprechenden Potentialbeaufschlagung der einzelnen Elektroden geeignet sind, Ladungsträger als Teilchenstrahl bzw. Teilchenteilstrahl durch die miteinander korrespondierenden Öffnungen der verschiedenen Elektroden hindurchtreten zu lassen. Dabei können die weiteren Elektroden in Teilchenaustrittsrichtung vor oder hinter der ersten Elektrode gemäß der vorliegenden Anmeldung angeordnet sein. Neben der ersten Elektrode gemäß der vorliegenden Anmeldung können auch noch weitere Elektroden mindestens eine Öffnung aufweisen, die wie die mindestens eine Öffnung in der ersten Elektrode ausgebildet ist.

Üblicherweise weist eine Vorrichtung zur Extraktion von Ladungsträgern mindestens zwei Elektroden auf, die mit unterschiedlichen elektrischen Potentialen während des Betriebes der Vorrichtung beaufschlagt werden. So kann bspw. eine Elektrode, die den Ladungsträgererzeugungsraum abschließt und abschirmt (Screenelektrode), mit einem hohen und der Ladung der elektrischen Ladungsträger entsprechenden Potential beaufschlagt werden. Das heißt, wenn die elektrischen Ladungsträger, die mit Hilfe der Vorrichtung aus dem Ladungsträgererzeugungsraum extrahiert werden sollen, positiv geladene Ionen sind, so ist das Potential ein positives Potential, während das Potential für negative Ionen oder Elektronen als Ladungsträger ein negatives Potential ist. Die Beaufschlagung der Screenelektrode mit einem Potential kann auch indirekt über eine weitere Elektrode im Ladungsträgererzeugungsraum erfolgen. Eine andere Elektrode, die zur Beschleunigung der Ladungsträger aus dem Ladungsträgererzeugungsraum in Teilchenaustrittsrichtung dient (Accelerationelektrode) und die erste Elektrode gemäß der vorliegenden Anmeldung ist, wird demgegenüber mit einem der Ladung der Ladungsträger entgegengesetzten Potential beaufschlagt, so dass es zu einem großen Potentialunterschied zwischen den beiden Elektroden kommt.

In einer bevorzugten Ausführungsform verläuft eine Verbindungslinie zwischen dem ersten Punkt der Öffnung und einem zweiten Punkt, der auf der Begrenzungslinie der Öffnung auf der zweiten Oberfläche der ersten Elektrode liegt, in der Querschnittsebene durch die Öffnung in einem Winkel von größer 0° zur Mittelpunktnormalen, wobei der zweite Punkt auf der zum ersten Punkt gehörigen ersten Innenseitenkurve liegt. Dabei ist der Winkel kleiner als 90°. Besonders bevorzugt liegt der Winkel im Bereich von 1° bis 35°.

Vorzugsweise berührt mindestens eine Innenseitenkurve der Öffnung der ersten Elektrode in der Querschnittsebene maximal die dazugehörige Verbindungslinie, schneidet diese jedoch nicht. Das heißt, jeder Punkt auf dieser Innenseitenkurve der Öffnung in der Querschnittsebene liegt auf der dazugehörigen Verbindungslinie oder von dieser beabstandet auf der Seite der Verbindungslinie, die nicht der Mittelpunktnormalen zugewandt ist. Besonders bevorzugt trifft dies für alle Innenseitenkurven der Öffnung in jeder Querschnittsebene zu. Damit ragt die Innenseite der Öffnung in keiner Querschnittsebene über die jeweilige Verbindungslinie in der Querschnittsebene hinaus.

Bei der Wahl des Winkels ist ein Optimum zwischen der Abschattung der Innenseiten der Öffnung gegenüber den von einem Substrat zurückgestreuten Materialteilchen, für die ein großer Winkel günstig ist, einerseits und der mechanischen Stabilität der ersten Elektrode, für die ein kleiner Winkel günstig ist, andererseits zu finden. Bei Gitterelektroden ist darüber hinaus der Abstand zwischen benachbarten Öffnungen auf der zweiten Oberfläche der ersten Gitterelektrode und damit die Transparenz der Vorrichtung zur Extraktion von elektrischen Ladungsträgern ein Kriterium, das die maximale Größe des Winkels beeinflusst. Für bekannte Größen einer Bearbeitungsvorrichtung, in der die Vorrichtung zur Extraktion von Ladungsträgern eingesetzt wird, insbesondere Größe eines durch die Ladungsträger bearbeiteten Oberflächenbereiches eines Substrates, Abstand der ersten Oberfläche der ersten Elektrode zur Oberfläche des Substrates, Dicke bzw. Höhe der ersten Elektrode und Öffnungsweite der Öffnung der ersten Elektrode auf der ersten Oberfläche der ersten Elektrode in der Querschnittsebene, kann ein erster Winkel für die Verbindungslinie berechnet werden, so dass für alle Winkel gleich oder größer als dieser erster Winkel eine Abschattung der Innenseiten der Öffnung erreicht wird, die nahezu vollständig oder zumindest so groß ist, dass die Nachteile des Standes der Technik überwunden werden. Die Öffnungsweite der Öffnung der ersten Elektrode auf der ersten Oberfläche der ersten Elektrode ist die Summe aus dem ersten Abstand und einem zweiten Abstand, den ein Punkt, der auf der Begrenzungslinie der spezifischen Öffnung auf der ersten Oberfläche der ersten Elektrode und auf der zweiten Innenseitenkurve der Öffnung in der Querschnittsebene liegt, zum Mittelpunkt der Öffnung in der ersten Oberfläche hat. Beispiele zur Berechnung des ersten Winkels werden anhand der Figuren später erläutert.

Vorzugsweise nimmt der Abstand der Punkte mindestens einer Innenseitenkurve von der Mittelpunktnormalen zwischen der ersten Oberfläche der ersten Elektrode und der zweiten Oberfläche der ersten Elektrode zu. Besonders bevorzugt nimmt er stetig zu.

In einer besonders bevorzugten Ausführungsform verläuft mindestens eine Innenseitenkurve der Öffnung der ersten Elektrode geradlinig zwischen der ersten und der zweiten Oberfläche der ersten Elektrode. Das heißt, in der dazugehörigen Querschnittsebene durch die erste Elektrode ist die Innenseite der Öffnung zumindest auf einer Seite der Öffnung eine Gerade, die sich von der ersten Oberfläche zur zweiten Oberfläche erstreckt

Alternativ kann mindestens eine Innenseitenkurve der Öffnung auch einen anderen Verlauf aufweisen. Beispielsweise kann der Abstand eines, von dem ersten Punkt verschiedenen Punktes der Innenseitenkurve, der näher an der ersten Oberfläche liegt, als ein anderer Punkt derselben Innenseitenkurve, zur Mittelpunktnormalen größer als der Abstand dieses anderen Punktes zur Mittelpunktnormalen sein. So kann die Öffnung bspw. eine bauchige Form im Querschnitt aufweisen.

Eine andere Alternative besteht in einem stufenförmigen Verlauf der Innenseite der Öffnung, so dass der Abstand der Punkte dieser Innenseitenkurve zur Mittelpunktnormalen über einen definierten Dickenbereich der ersten Elektrode hinweg gleichbleibt und sich danach sprunghaft oder allmählich zu einem anderen Dickenbereich der ersten Elektrode hin ändert. Ein Dickenbereich der ersten Elektrode ist dabei ein Bereich der ersten Elektrode, der sich in Teilchenaustrittsrichtung von einer ersten Dickenebene bis zu einer zweiten Dickenebene erstreckt und an die Öffnung angrenzt. Eine Dickenebene ist eine Ebene, die senkrecht zur Teilchenaustrittsrichtung verläuft und zwischen der ersten Oberfläche und der zweiten Oberfläche der ersten Elektrode angeordnet ist.

Weist die erste Elektrode eine Vielzahl von Öffnungen zum Durchtritt von Ladungsträgern auf, d.h. die erste Elektrode ist eine Gitterelektrode wie oben beschrieben, so ist vorzugsweise jede Öffnung so wie oben beschrieben ausgebildet. Dabei können verschiedene Öffnungen verschieden ausgebildet sein, d.h. insbesondere verschiedene Formen in einer Ebene, die senkrecht zur Teilchenaustrittsrichtung verläuft, verschiedene erste und/oder zweite Abstände, verschiedene Winkel der Verbindungslinie und/oder verschiedene Verläufe der Innenseiten der Öffnung haben.

Die erfindungsgemäße Vorrichtung zur Extraktion von elektrischen Ladungsträgern weist eine Standzeit auf, die gegenüber der Standzeit einer Vorrichtung zur Extraktion von elektrischen Ladungsträgern gemäß dem Stand der Technik um den Faktor 10 bis 30 verlängert ist.

Im Nachfolgenden soll die Erfindung anhand von Ausführungsbeispielen und Figuren verdeutlicht werden, wobei keine maßstäbliche Darstellung der einzelnen Komponenten und Elemente gegeben ist.

Es zeigen:

| | |
|---|---|
| Fig. 1 | eine schematische Darstellung der erfindungsgemäßen Vorrichtung in einer ersten Ausführungsform mit drei Gitterelektroden im Querschnitt, |
| Fig. 2 | einen Ausschnitt aus der Fig. 1 zur Erläuterung der Ausgestaltung der ersten Elektrode, |
| Fig. 3A | eine Draufsicht auf eine Öffnung der ersten Elektrode aus Fig. 2, |
| Fig. 3B | eine vergrößerte Ansicht der Öffnung aus Fig. 3A im Querschnitt entlang der Linie A-A', |
| Fig. 4A | eine schematische Darstellung einer fokussierenden, erfindungsgemäßen Vorrichtung zur Extraktion von elektrischen Ladungsträgern, so dass ein kleiner Bereich einer Substratoberfläche durch die Teilchenstrahlen bearbeitet wird, |
| Fig. 4B | eine schematische Darstellung für die Berechnung des ersten Winkels für die Vorrichtung in Fig. 4A, |
| Fig. 5 | eine schematische Darstellung für die Berechnung des ersten Winkels für den Fall, dass ein großer Bereich einer Substratoberfläche durch die Teichenstrahlen bearbeitet wird, |
| Fig. 6 | eine schematische Darstellung einer weiteren Möglichkeit zur Ausgestaltung einer Vorrichtung zur Extraktion von Ladungsträgern aus einem Ladungsträgererzeugungsraum, bei der die Ablagerung von Material auf der Innenseite der Öffnungen einer Gitterelektrode verringert ist, |
| Fig. 7A bis 7C | schematische Darstellungen zur Erläuterung anderer Möglichkeiten zur Ausgestaltung der ersten Elektrode, mit der die Entstehung von Bogenentladungen verringert oder vermieden werden können, und |
| Fig. 8 | eine schematische Darstellung eines Verfahrens, mit dem Ablagerungen von rückgestreutem Material verringert oder deren Abplatzen vermieden werden kann. |

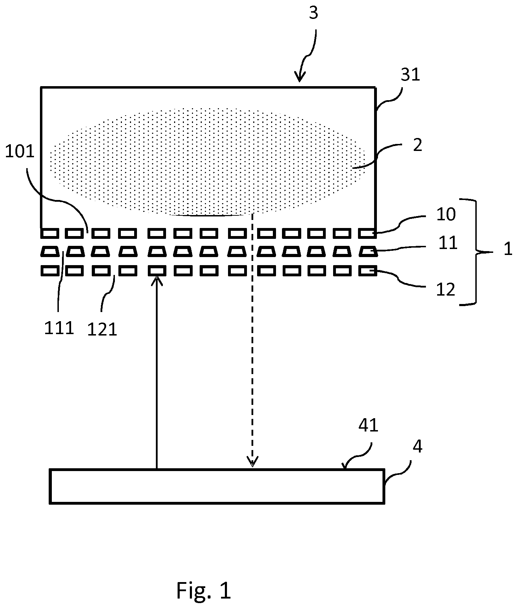

Figur 1 zeigt schematisch eine Vorrichtung (1) zur Extraktion von elektrischen Ladungsträgern aus einem Ladungsträgererzeugungsraum (2) einer Teilchenstrahlquelle (3) in einer Querschnittsansicht. Der Ladungsträgererzeugungsraum (2) ist bspw. ein Plasma, das innerhalb eines Gehäuses (31) der Teilchenstrahlquelle (3) erzeugt wird. Dabei können kapazitive, induktive oder mikrowellen-gestützte Verfahren zur Erzeugung des Plasmas eingesetzt werden. Auch Hot-filament-Quellen oder andere Möglichkeiten zur Bereitstellung von elektrischen Ladungsträgern im Ladungsträgererzeugungsraum (2) können verwendet werden. Bspw. können Elektronenkanonen oder Ionenkanonen zum Einsatz kommen. Die konkrete Ausgestaltung des Ladungsträgererzeugungsraumes (2) ist frei wählbar, solange ein ausreichender Vorrat an elektrischen Ladungsträgern an der Vorrichtung (1) zur Extraktion von elektrischen Ladungsträgern vorliegt. Die Vorrichtung (1) zur Extraktion von elektrischen Ladungsträgern ist in oder an der Teilchenstrahlquelle (3) angeordnet und wird während des Betriebes der Vorrichtung (1) mit einem oder mehreren elektrischen Potentialen beaufschlagt Es können auch mehrere Vorrichtungen zur Extraktion von elektrischen Ladungsträgern aus ein und demselben Ladungsträgererzeugungsraum in oder an einer Teilchenstrahlquelle angeordnet sein.

Die Vorrichtung (1) zur Extraktion von elektrischen Ladungsträgern besteht in der Regel aus mehreren Elektroden, enthält aber mindestens eine Elektrode zur Extraktion von elektrischen Ladungsträgern, die mit einem hohen, dem Potential der zu extrahierenden elektrischen Ladungsträger entgegengesetzten elektrischen Potential beaufschlagt wird. In dem in Fig. 1 gezeigten Beispiel enthält die Vorrichtung (1) zur Extraktion von Ladungsträgern Gitterelektroden, insbesondere eine Screenelektrode (10), eine erste Elektrode (11) und eine Masseelektrode (12). Die genannten Gitterelektroden sind in Teilchenaustrittsrichtung in dieser Reihenfolgen hintereinander angeordnet, so dass vom Ladungsträgererzeugungsraum (2) aus gesehen zunächst die Screenelektrode (10), dann die erste Elektrode (11) und zuletzt die Masseelektrode (12) von den elektrischen Ladungsträgern passiert werden. Die Screenelektrode (10) dient der Abschirmung des Plasmas im Ladungsträgererzeugungsraum (2) gegenüber der Umgebung und wird im Betrieb mit einem der Ladung der zu extrahierenden Ladungsträger entsprechendem hohen Potential, bspw. + 1000 V für positive Ionen, beaufschlagt. An der Screenelektrode (10) erfolgt an der Randschicht des Ladungsträgererzeugungsraumes (2) die Extraktion der Ladungsträger aus dem Ladungsträgererzeugungsraum (2). Die erste Elektrode (11) dient der Beschleunigung der zu extrahierenden Ladungsträger und wird mit einem der Ladung der zu extrahierenden Ladungsträger entgegengesetztem Potential, z. B. - 100 V für positive Ionen, beaufschlagt. Die Masseelektrode (12) wird mit Masse verbunden. Damit liegt ein großer Potentialunterschied, von bspw. 1100 V, zwischen der Screenelektrode (10) und der ersten Elektrode (11) vor.

Jede Gitterelektrode weist eine Vielzahl von Öffnungen (101, 111, 121) auf, die sich über die gesamte Dicke bzw. Höhe der jeweiligen Gitterelektrode erstrecken, wobei die Höhe in Teilchenaustrittsrichtung, in Fig. 1 durch den gestrichelten Pfeil gekennzeichnet, definiert ist

Die extrahierten Ladungsträger treten durch zueinander korrespondierende Öffnungen (101, 111, 121) der Screenelektrode (10), ersten Elektrode (11) und Masseelektrode (12) als Teilchenteilstrahl in Teilchenaustrittsrichtung hindurch und bilden einen Teilchenstrahl, der auf die Oberfläche (41) eines Substrates (4) trifft und diese bearbeitet. Die einzelnen Gitterelektroden können vollkommen eben oder mit einem Radius derart ausgebildet sein, dass die einzelnen Teilchenteilstrahlen bis zu ihrem Auftreffen auf die Substratoberfläche (41) auch fokusiert oder defokusiert werden können. Unter "Bearbeiten" der Substratoberfläche (41) werden im Sinne dieser Anmeldung insbesondere Verfahren, bei denen Material von der Substratoberfläche (41) abgetragen wird, bspw. Sputtern oder Ionenstrahlätzen, verstanden. Abgetragene Materialteilchen werden von der Substratoberfläche (41) dabei auch in Richtung der Vorrichtung (1) zur Extraktion von elektrischen Ladungsträgern zurückgestreut, was durch den nicht unterbrochenen Pfeil dargestellt ist. Die Gitterelektroden bestehen bspw. aus Graphit, auf dem z.B. Silizium (Si), das von der Substratoberfläche (41) zurückgestreut wird, schlecht haftet.

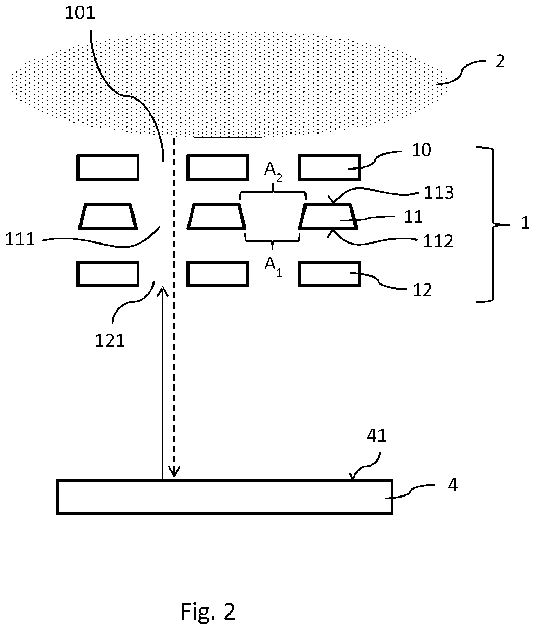

Mit Bezug auf Fig. 2 wird die besondere Ausgestaltung der Öffnungen der ersten Elektrode (11) genauer erläutert. Dazu zeigt Fig. 2 einen Ausschnitt aus der erfindungsgemäßen Vorrichtung (1) zur Extraktion von elektrischen Ladungsträgern, mit jeweils nur zwei Öffnungen (101, 111, 121) der Elektroden (10, 11, 12). Die Öffnungen (101) in der Screenelektrode (10) und die Öffnungen (121) in der Masseelektrode (12) sind gemäß dem Stand der Technik ausgebildet und haben eine Kreisform in einer Ebene, senkrecht zur Teilchenaustrittrichtung, und eine zylindrische räumliche Form. Damit haben alle Punkte auf den Innenseitenkurven einer solchen Öffnung (101, 121) einen annähernd gleichen Abstand zu einer Mittelpunktnormalen über die gesamte Ausdehnung dieser Öffnung (101, 121). Demgegenüber weisen die Öffnungen (111) in der ersten Elektrode (11) eine andere Gestalt auf: Im dargestellten Ausführungsbeispiel haben die Öffnungen (111) die räumliche Form eines Kegelstumpfes. Jede dieser Öffnungen (111) erstreckt sich von einer ersten Oberfläche (112) der ersten Elektrode (11) bis zu einer zweiten Oberfläche (113) der ersten Elektrode (11). Die erste Oberfläche (112) ist dem Ladungsträgererzeugungsraum (2) abgewandt und der Substratoberfläche (41) zugewandt, während die zweite Oberfläche (113) dem Ladungsträgererzeugungsraum (2) zugewandt und der Substratoberfläche (41) abgewandt ist. Damit hat eine solche Öffnung (111) einen ersten Flächeninhalt ($A_1$) auf der ersten Oberfläche (112), der kleiner ist als ein zweiter Flächeninhalt ($A_2$) auf der zweiten Oberfläche (113). Darüber hinaus ist der erste Flächeninhalt ($A_1$) im dargestellten Fall kleiner als alle weiteren Flächeninhalte, die diese Öffnung in weiteren Dickenebenen hat. Eine Dickenebene ist dabei eine Ebene, die senkrecht zur Teilchenaustrittsrichtung (gestrichelter Pfeil in Fig. 2) verläuft und zwischen der ersten Oberfläche (112) und der zweiten Oberfläche (113) angeordnet ist. Mit anderen Worten: Punkte der Innenseitenkurven einer solchen Öffnung (111), die nicht auf der ersten Oberfläche (112) angeordnet sind, haben einen größeren Abstand zu einer Mittelpunktnormalen als die Punkte der Innenseitenkurven, die auf der ersten Oberfläche (112) angeordnet sind. Damit lagern sich abgetragene Materialteilchen, die sich von der Substratoberfläche (41) in Richtung der Elektroden (10, 11, 12) bewegen (dargestellt durch den durchgezogenen Pfeil in Fig. 2), hauptsächlich auf der der Substratoberfläche (41) zugewandten Oberfläche der Masseelektrode (12) und den Innenseiten der Öffnungen (121) in der Masseelektrode (12) sowie der Öffnungen (101) in der Screenelektrode (10), jedoch nur in stark verringertem Maße an den Innenseiten der Öffnungen (111) der ersten Elektrode (11) ab.

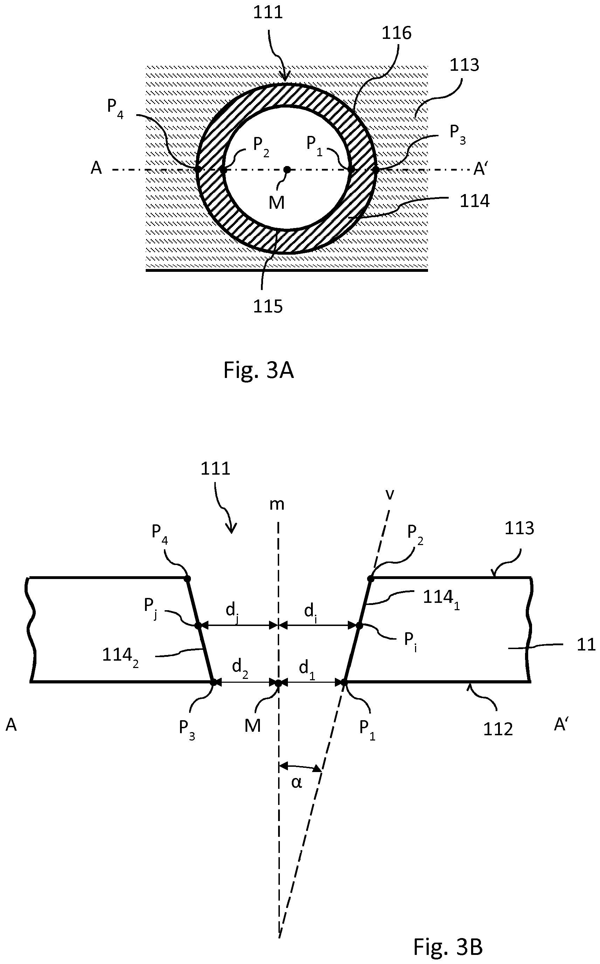

Zur weiteren Erläuterung der Ausgestaltung der Öffnungen (111) in der ersten Elektrode (11) ist in Fig. 3A eine Draufsicht auf die zweite Oberfläche (113) der ersten Elektrode und eine spezifische Öffnung (111) und in Fig. 3B eine stark vergrößerte Ansicht dieser Öffnung (111) im Querschnitt entlang der Linie A-A' durch die erste Elektrode (11) dargestellt.

Die Öffnung (111) hat auf der ersten Oberfläche eine erste Begrenzungslinie (115) und auf der zweiten Oberfläche (113) eine zweite Begrenzungslinie (116). Im dargestellten Fall ist die Öffnung (111) in der Draufsicht in allen Dickenebenen kreisförmig, wobei die Mittelpunkte der Kreisflächen auf einer Geraden entlang der Teilchenaustrittsrichtung liegen, so dass die Öffnung (111) eine Innenseite (114) aufweist, die eine Mantelfläche eines Kegelstumpfes beschreibt. In Fig. 3A ist nur der Mittelpunkt (M) der Öffnung (111) an der ersten Oberfläche eingezeichnet. Die Öffnung (111) hat auf der ersten Oberfläche eine Kreisfläche, begrenzt durch die erste Begrenzungslinie (115), mit einem ersten Flächeninhalt, und auf der zweiten Oberfläche (113) eine Kreisfläche, begrenzt durch die zweite Begrenzungslinie (116), mit einem zweiten Flächeninhalt. Der erste Flächeninhalt, der dem weißen Innenkreis in Fig. 3A entspricht, ist kleiner als der zweite Flächeninhalt, der dem weißen Innenkreis zusammen mit dem schraffierten Kreisring in Fig. 3A entspricht, und ist der kleinste Flächeninhalt aller Kreisflächen, die die Öffnung (111) auf verschiedenen Dickenebenen hat. Entlang der Schnittlinie A-A', die durch den Mittelpunkt (M) der Öffnung (111) auf der ersten Oberfläche verläuft, liegen vier Punkte ($P_1$ bis $P_4$) auf der Innenseite (114) der Öffnung (111). Der erste Punkt ($P_1$) und der dritte Punkt ($P_3$) liegen auf der ersten Begrenzungslinie (115), während der zweite Punkt ($P_2$) und der vierte Punkt ($P_4$) auf der zweiten Begrenzungslinie (116) liegen.

Im Querschnitt durch die Öffnung (111) entlang der Linie A-A', der in Fig. 3B dargestellt ist, fällt die Gerade, die die Mittelpunkte aller Kreisflächen der Öffnung (111) in den senkrecht zur Querschnittsebene und parallel zur ersten Oberfläche (112) verlaufenden Dickenebenen verbindet, mit der Mittelpunktnormalen (m) zusammen. Die Mittelpunktnormale (m) ist die Normale auf die erste Oberfläche (112), wenn die erste Oberfläche (112) wie im dargestellten Fall eine Ebene ist, oder auf die Tangente an die erste Oberfläche, wenn die erste Oberfläche eine gekrümmte Fläche ist, im Mittelpunkt (M) der Öffnung (111) an der ersten Oberfläche (112). Es sind auch Fälle denkbar, bei denen die Mittelpunkte der Öffnung nicht in allen Dickenebenen übereinander auf der Mittelpunktnormalen (m) liegen, bspw. wenn die Öffnung die räumliche Form eines schiefen Kegelstumpfes hat. Im Querschnitt sind wieder der erste bis vierte Punkt ($P_1$ bis $P_4$) eingezeichnet. Die Innenseite der Öffnung (111) beschreibt zwischen dem ersten Punkt ($P_1$) und dem zweiten Punkt ($P_2$) eine erste Innenseitenkurve ($114_1$) im Querschnitt, während die Innenseite der Öffnung (111) zwischen dem dritten Punkt ($P_3$) und dem vierten Punkt ($P_4$) eine zweite Innenseitenkurve ($114_2$) beschreibt. Im dargestellten Fall verlaufen die erste Innenseitenkurve ($114_1$) und die zweite Innenseitenkurve ($114_2$) geradlinig vom ersten Punkt ($P_1$) zum zweiten Punkt ($P_2$) bzw. vom dritten Punkt ($P_3$) zum vierten Punkt ($P_4$). Die Verbindungslinie (v) zwischen dem ersten Punkt ($P_1$) und dem zweiten Punkt ($P_2$) fällt im dargestellten Fall mit der ersten Innenseitenkurve ($114_1$) zusammen, wobei die Verbindungslinie (v) in einem Winkel $\alpha$ zur Mittelpunktnormalen (m) verläuft. Auch zwischen dem dritten Punkt ($P_3$) und dem vierten Punkt ($P_4$) kann eine Verbindungslinie erzeugt werden (nicht in Fig. 3B dargestellt), die im selben oder in einem anderen Winkel zur Mittelpunktnormalen (m) wie $\alpha$ verlaufen kann. Für den dargestellten Fall von konzentrischen Kreisen, die die Öffnung (111) bilden, sind beide Winkel gleich. Jedoch können die Innenseitenkurven auch einen anderen Verlauf, bspw. einen stufenförmigen oder einen kurvigen Verlauf aufweisen, wobei jedoch vorzugweise jeder Punkt auf einer Innenseitenkurve der Öffnung auf der Verbindungslinie zwischen dem ersten Punkt ($P_1$) und dem zweiten Punkt ($P_2$) bzw. dem dritten Punkt ($P_3$) und dem vierten Punkt ($P_4$) oder weiter entfernt von der Mittelpunktnormalen als die entsprechende Verbindungslinie liegt.

Der erste Punkt ($P_1$) hat einen erste Abstand ($d_1$) zum Mittelpunkt (M) der Öffnung (111) in der ersten Oberfläche (112), während der dritte Punkt ($P_3$) einen zweiten Abstand ($d_2$) zum Mittelpunkt (M) der Öffnung (111) in der ersten Oberfläche (111) aufweist. Im dargestellten Fall von konzentrischen Kreisen, die die Öffnung (111) bilden, ist der erste Abstand ($d_1$) gleich dem zweiten Abstand ($d_2$). Jeder weitere Punkt ($P_i$) auf der ersten Innenseitenkurve ($114_1$) hat einen Abstand ($d_i$) zur Mittelpunktnormalen (m), der größer oder gleich dem ersten Abstand ($d_1$) ist, wobei mindestens die Hälfte aller Punkte ($P_i$) einen größeren Abstand ($d_i$) aufweist. Im dargestellten Fall haben alle Punkte ($P_i$) einen Abstand ($d_i$), der größer als der erste Abstand ($d_1$) ist. Gleiches gilt für die zweite Innenseitenkurve ($114_2$): Hier haben alle Punkte ($P_j$), die auf der zweiten Innenseitenkurve ($114_2$) liegen, einen Abstand ($d_j$) zur Mittelpunktnormalen (m), der größer oder gleich dem zweiten Abstand ($d_2$) ist, wobei mindestens die Hälfte aller Punkte ($P_j$) einen größeren Abstand ($d_j$) als den zweiten Abstand ($d_2$) haben. Im dargestellten Fall haben alle Punkte ($P_i$, $P_j$), die auf der ersten oder zweiten Innenseitenkurve ($114_1$, $114_2$) liegen und nicht der erste oder der zweite Punkt ($P_1$, $P_2$) sind, einen Abstand ($d_i$, $d_j$) zur Mittelpunktnormalen (m), der größer als der erste bzw. der zweite Abstand ($d_1$, $d_2$) ist.

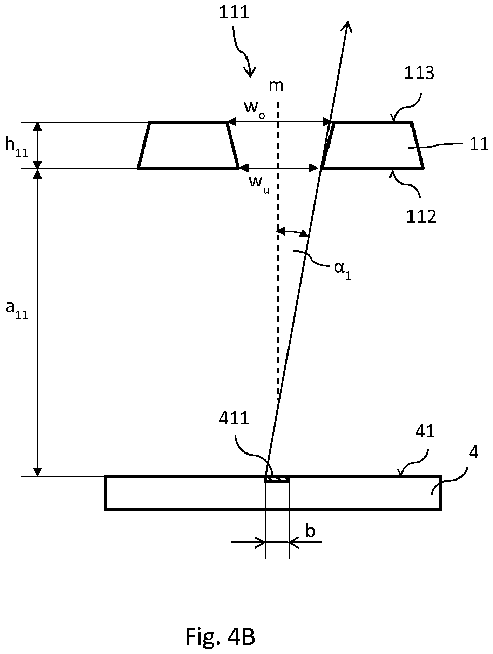

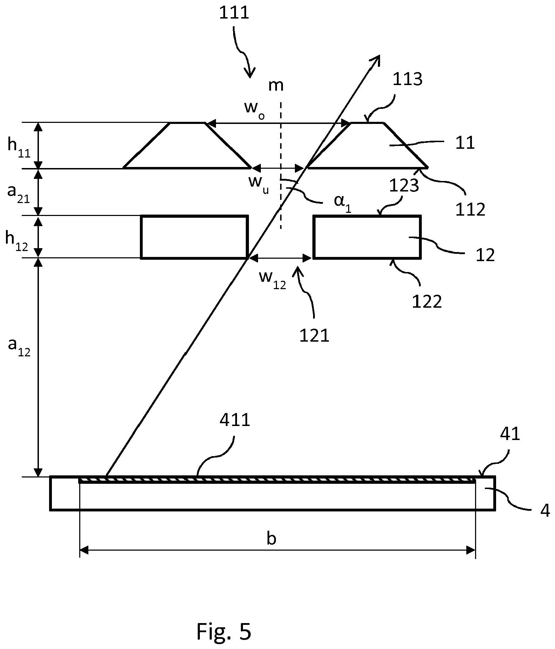

Anhand der Figuren 4B und 5 wird die Berechnung eines ersten Winkels $\alpha_1$ erläutert, der eine sehr große bis nahezu vollständige Abschattung der Innenseiten der mindestens einen Öffnung der ersten Elektrode gewährleistet. Der erste Winkel $\alpha_1$ ist die minimale Größe des Winkels $\alpha$ der Verbindungslinie unter der Voraussetzung, dass die Innenseitenkurven der Öffnung diese Verbindungslinie nicht schneidet. Dabei wird jeweils von einer Vorrichtung zur Extraktion von elektrischen Ladungsträgern ausgegangen, die Gitterelektroden enthält. Die angegebenen Berechnungen sind Abschätzungen für ein gaußförmiges Profil der Materialabtragung von der Substratoberfläche. Es wird an dieser Stelle noch einmal darauf hingewiesen, das auch Öffnungen, deren Innenseitenkurven einen kleineren Winkel als den ersten Winkel $\alpha_1$ aufweisen, bereits eine teilweise Abschattung der Innenseiten der Öffnung ermöglichen und damit zu einer Verbesserung der Standzeit der Vorrichtung zur Extraktion von elektrischen Ladungsträgern führen.

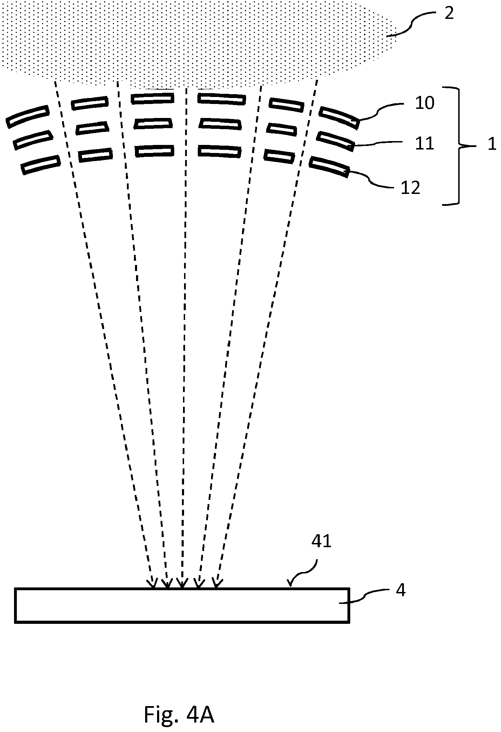

Mit Bezug auf Figur 4B wird die Berechnung eines ersten Winkels $\alpha_1$ für den Fall, dass ein kleiner Bereich einer Substratoberfläche durch die Teilchenstrahlen bearbeitet wird, erläutert. Dazu ist die Vorrichtung (1) zur Extraktion von elektrischen Ladungsträgern als fokussierende Anordnung von (Gitter-)Elektroden (10, 11, 12) ausgebildet, wie dies in Fig. 4A schematisch dargestellt ist. Es sind die Screenelektrode (10), die erste Elektrode (11) und die Masseelektrode (12) gezeigt, die nicht planar, sondern gekrümmt sind. Die Elektroden (10, 11, 12) bilden im dargestellten Querschnitt jeweils einen Ausschnitt aus einem Kreisring ab, dessen Innenradius gleich, kleiner oder größer als der Abstand einer einem Substrat (4) zugewandten ersten Oberfläche der jeweiligen Elektrode (10, 11, 12) von der Oberfläche (41) des Substrates (4) ist und die einen gemeinsamen Mittelpunkt haben, der auf dem Substrat (4), davor oder dahinter in Teilchenaustrittsrichtung liegt. Durch die sphärische Geometrie der Elektroden (10, 11, 12) der Vorrichtung (1) zur Extraktion von elektrischen Ladungsträgern wird ein fokussierter Teilchenstrahl erzeugt, mit dem eine kleinflächige Bearbeitung der Substratoberfläche (41) möglich ist.

Die schematische Darstellung der Fig. 4B zeigt nur die erste Elektrode (11) mit einer Öffnung (111), wobei die Krümmung der Elektrode hier vernachlässigt wurde und nicht dargestellt ist, und das Substrat (4) mit einem Bereich (411) der Substratoberfläche (41), der durch den Teilchenstrahl, der durch die Vorrichtung zur Extraktion von elektrischen Ladungsträgern erzeugt wird, bearbeitet wird, wobei ca. 90 % der Teilchen des Teilchenstrahls in diesem Bereich (411) auftreffen. Dieser Bereich (411) ist relativ klein, bspw. hat er eine Breite b = 10 mm. Die erste Oberfläche (112) der ersten Elektrode (11) befindet sich in einem Abstand $a_{11}$ von der Substratoberfläche (41), wobei der Abstand $a_{11}$ bspw. in einem Bereich von 60 bis 110 mm liegt. Die erste Elektrode (11) hat eine Höhe $h_{11}$, die im Bereich von 0,2 bis 3 mm liegt. Die Öffnung (111) in der ersten Elektrode (11) hat auf der ersten Oberfläche (112) eine untere Öffnungsweite ($w_u$) und auf der zweiten Oberfläche (113) eine obere Öffnungsweite ($w_o$). Unter Öffnungsweite wird in jeder spezifischen Querschnittsebene die Summe des Abstandes eines spezifischen Punktes auf der ersten Innenseitenkurve zur Mittelpunktnormalen (m) und des Abstandes eines anderen spezifischen Punktes auf der zweiten Innenseitenkurve zur Mittelpunktnormalen (m) verstanden, wobei die beiden spezifischen Punkte auf einer senkrecht zur Mittelpunktnormalen und senkrecht zur Querschnittsebene verlaufenden Dickenebene liegen. Das heißt, die untere Öffnungsweite ($w_u$) ist die Summe aus dem ersten Abstand ($d_1$) und dem zweiten Abstand ($d_2$), während die obere Öffnungsweite ($w_o$) die Summe aus dem Abstand des zweiten Punktes zur Mittelpunktnormalen (m) und dem Abstand des vierten Punktes zur Mittelpunktnormalen (m) ist. Für den Fall, dass die Öffnung (111) immer die Form eines Kreises in allen Dickenebenen hat, ist die Öffnungsweite der Durchmesser der Öffnung (111) in der spezifischen Dickenebene.

Unter der Voraussetzung, dass die Elektroden, die zwischen der Substratoberfläche (41) und der ersten Elektrode (11) angeordnet sind, Öffnungen haben, deren Öffnungsweite groß genug ist, um die meisten rückgestreuten Materialteilchen (dargestellt durch den durchgezogenen Pfeil) hindurchtreten zu lassen, berechnet sich der erste Winkel $\alpha_1$ wie folgt:

$$\alpha_1 = \arctan\left(\frac{b+w_u}{2 \cdot a_{11}}\right) \qquad (1).$$

Damit ergibt sich für einen Abstand $a_{11}$ = 62 mm, eine Breite b = 10 mm und eine untere Öffnungsweite $w_u$ = 1,5 mm ein erster Winkel $\alpha_1$ von 5,3°. Gemäß der Formel (2)

$$w_o = 2 \cdot \left(h_{11} \cdot \tan\left(\alpha_1\right) + \frac{w_u}{2}\right) \quad (2)$$

ergibt sich damit für eine Höhe $h_{11}$ = 1 mm eine obere Öffnungsweite von $w_o$ = 1,69 mm.

Bei einem geradlinigen Verlauf der Innenseitenkurve kann damit die Ablagerung von ca. 90 % aller rückgestreuten Materialteilchen vermieden werden.

Mit Bezug auf Figur 5 wird die Berechnung des ersten Winkels für den Fall, dass ein großer Bereich einer Substratoberfläche durch die Teilchenstrahlen bearbeitet wird, erläutert. In diesem Fall werden die Teilchenstrahlen durch die planaren Elektroden der Vorrichtung zur Extraktion von elektrischen Ladungsträgern nicht fokussiert, so dass die Teilchenteilstrahlen aus der Teilchenstrahlquelle parallel zueinander auf die Oberfläche (41) des Substrates (4) auftreffen. Da der bearbeitete Bereich (411) sehr groß ist, bspw. eine Breite b von 150 mm aufweist, wird der erste Winkel $\alpha_1$ nicht mehr durch die Größe des bearbeiteten Bereiches (411) bestimmt, wie dies bei Fig. 4B der Fall war, sondern durch die geometrische Abschattung zurückgestreuter Materialteilchen (in Fig. 5 durch den durchgezogenen Pfeil dargestellt) durch Elektroden, die zwischen der ersten Elektrode (11) und dem Substrat (4) angeordnet sind. Im Ausführungsbeispiel ist dies die Masseelektrode (12). Die Öffnung (121) in der Masseelektrode (12) hat eine Öffnungsweite $w_{12}$, die über die gesamte Ausdehnung der Öffnung (121) von einer ersten Oberfläche (122) der Masseelektrode (12) bis zu einer zweiten Oberfläche (123) der Masseelektrode (12) nahezu konstant ist. Die erste Oberfläche (122) der Masseelektrode (12) ist dem Substrat (4) zugewandt, während die zweite Oberfläche (123) der Masseelektrode (12) der ersten Elektrode (11) zugewandt ist. Die erste Oberfläche (122) der Masseelektrode (12) befindet sich in einem Abstand $a_{12}$ von der Substratoberfläche (41), wobei der Abstand $a_{12}$ bspw. in einem Bereich von 60 bis 110 mm liegt. Die erste Oberfläche (112) der ersten Elektrode (11) befindet sich in einem Abstand $a_{21}$ von der zweiten Oberfläche (123) der Masseelektrode (12), wobei der Abstand $a_{21}$ bspw. in einem Bereich von 1 bis 5 mm liegt. Die erste Elektrode (11) hat eine Höhe $h_{11}$ und die Masseelektrode (12) hat eine Höhe $h_{12}$, die jeweils im Bereich von 1 bis 3 mm liegen. Die Öffnung (111) in der ersten Elektrode (11) hat auf der ersten Oberfläche (112) eine untere Öffnungsweite ($w_u$) und auf der zweiten Oberfläche (113) eine obere Öffnungsweite ($w_o$). Die Öffnungsweite wird wie mit Bezug auf Fig. 4B beschrieben definiert.

Damit berechnet sich der erste Winkel $\alpha_1$ wie folgt:

$$\alpha_1 = \arctan\left(\frac{w_{12}+w_u}{2\cdot(h_{12}+a_{21})}\right) \qquad (3).$$

Damit ergibt sich für einen Abstand $a_{21}$ = 3 mm, eine Höhe $h_{12}$ = 1 mm, eine Öffnungsweite $w_{12}$ = 2 mm und eine untere Öffnungsweite $w_u$ = 1,1 mm ein erster Winkel $\alpha_1$ von 21,2°. Gemäß der bereits mit Bezug auf Fig. 4B formulierten Formel (2) ergibt sich damit für eine Höhe $h_{11}$ = 1 mm eine obere Öffnungsweite von $w_o$ = 1,875 mm.

Bei einem geradlinigen Verlauf der Innenseitenkurve kann damit die Ablagerung der meisten aller rückgestreuten Materialteilchen vermieden werden, so dass sich die Standzeit der Vorrichtung zur Extraktion von elektrischen Ladungsträgern wiederum stark verlängert.

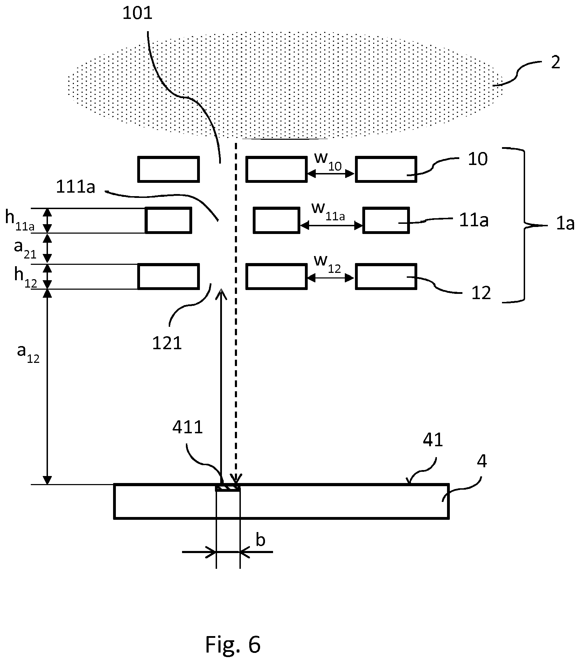

Anhand von Fig. 6 wird nun schematisch eine weitere Möglichkeit zur Ausgestaltung einer Vorrichtung zur Extraktion von Ladungsträgern aus einem Ladungsträgererzeugungsraum, bei der die Ablagerung von Material auf der Innenseite der Öffnungen einer Gitterelektrode verringert ist, erläutert. Dazu zeigt Fig. 6 eine Vorrichtung (1a), die wiederum eine Screenelektrode (10), eine erste Elektrode (11a) und eine Masseelektrode (12) enthält. Dabei weisen die Screenelektrode (10) mindestens eine Öffnung (101) mit einer Öffnungsweite $w_{10}$, die erste Elektrode (11a) mindestens eine Öffnung (111a) mit einer Öffnungsweite $w_{11a}$ und die Masseelektrode (12) mindestens eine Öffnung (121) mit einer Öffnungsweite $w_{12}$ auf. Alle Öffnungen (101, 111a, 121) haben dabei eine zylindrische räumliche Form, so dass die jeweilige Öffnungsweite der Öffnungen (101, 111a, 121) nahezu konstant über die gesamte Ausdehnung der jeweiligen Öffnung über die Dicke der jeweiligen Elektrode (10, 11a, 12) ist. Um eine Ablagerung von rückgestreuten Materialteilchen auf den Innenseiten der Öffnungen (111a) der ersten Elektrode (11a) zu verringern oder zu vermeiden, ist die Öffnungsweite $w_{11a}$ der Öffnung (111a) der ersten Elektrode (11a) gegenüber der Öffnungsweite ($w_{10}$, $w_{12}$) der korrespondierenden Öffnungen (101, 121) in der Screenelektrode (10) und der Masseelektrode (12) vergrößert. Das heißt: $w_{11a} > w_{10}$ und $w_{11a} > w_{12}$. Damit werden rückgestreute Materialteilchen hauptsächlich auf der, dem Substrat (4) zugewandten Oberfläche der Masseelektrode (12) sowie den Innenseiten der Öffnungen (101, 121) in der Screenelektrode (10) bzw. der Masseelektrode (12) abgelagert. Die minimale Öffnungsweite $w_{11amin}$ der Öffnung (111a) der ersten Elektrode (11a) berechnet sich dabei nach den folgenden Formel (4) bzw. (5):

- für den Fall einer kleinflächigen Bearbeitung der Substratoberfläche (41) mit einem fokussierten Teilchenstrahl:

$$w_{11amin} = w_{12} + (b + w_{12}) \cdot \frac{a_{21}+h_{11a}}{a_{12}+h_{12}} \qquad (4)$$

- für den Fall einer großflächigen Bearbeitung der Substratoberfläche (41) mit parallelen Teilchenteilstrahlen:

$$w_{11amin} = w_{12} \cdot \frac{h_{11a}+a_{21}}{h_{12}} \qquad (5)$$

wobei b die Breite des bearbeiteten Oberflächenbereiches (411), $a_{12}$ der Abstand der dem Substrat (4) zugewandten Oberfläche der Masseelektrode (12) zum Substrat (4), $a_{21}$ der Abstand zwischen der der ersten Elektrode (11a) zugewandten Oberfläche der Masseelektrode (12) und der der Masseelektrode (12) zugewandten Oberfläche der ersten Elektrode (11a), $h_{12}$ die Höhe der Masseelektrode (12) und $h_{11a}$ die Höhe der ersten Elektrode (11a) ist.

Damit muss die Öffnungsweite $w_{11a}$ der Öffnung (111a) in der ersten Elektrode (11a) derart vergrößert oder im Gegenzug die Öffnungsweite $w_{12}$ der Öffnung (121) in der Masseelektrode (12) derart verkleinert werden, dass die Masseelektrode (12) eine Abschirmung der Innenseiten der Öffnung (111 a) der ersten Elektrode (11a) gewährleistet. Die Öffnungsweiten $w_{12}$ und $w_{11a}$ sind dabei so zu wählen, dass zum einen die mechanische Stabilität der ersten Elektrode (11a) gewährleistet und der Abstand zwischen verschiedenen Öffnungen (121) in der Masseelektrode (12) nicht zu groß und damit die Transparenz der Vorrichtung (1a) zur Extraktion von Ladungsträgern nicht zu stark eingeschränkt wird.

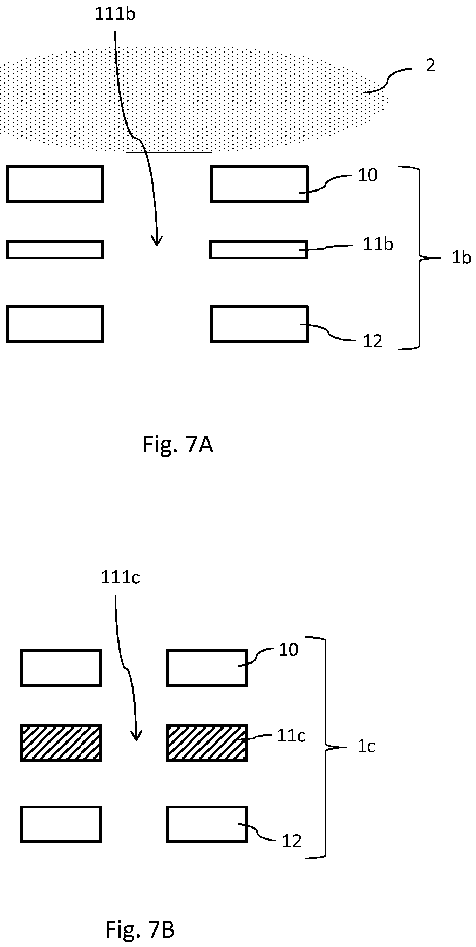

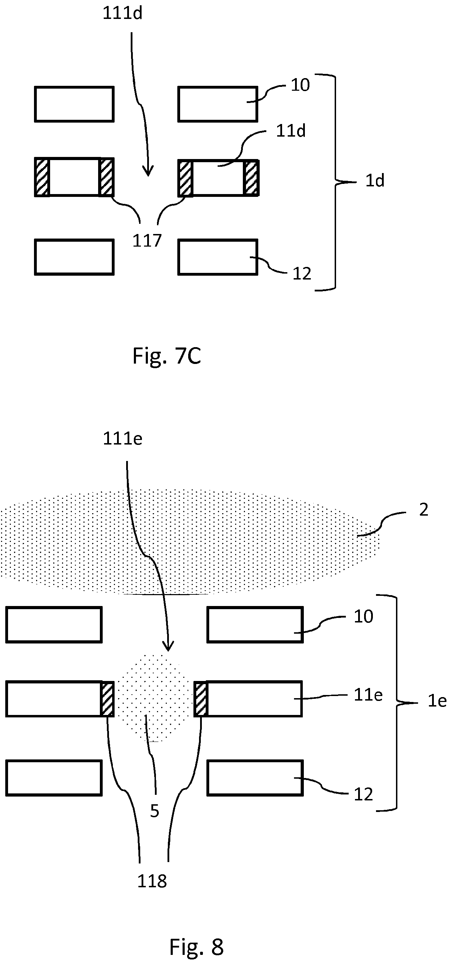

Die Fig. 7A bis 7C und 8 sind schematische Darstellungen zur Erläuterung anderer Möglichkeiten zur Vermeidung der Entstehung von Bogenentladungen. Bei diesen Varianten wird die Geometrie der Öffnungen in der ersten Elektrode, d.h. Öffnungsweite und räumliche Form, nicht gegenüber dem Stand der Technik geändert, sondern die Ablagerung von Materialteilchen an den Innenseiten der Öffnungen der ersten Elektrode werden anderweitig verringert oder es wird verhindert, dass Ablagerungen von den Innenseiten der Öffnungen abplatzen und damit Bogenentladungen begünstigen, oder abgelagerte Materialteilchen werden zumindest zyklisch wieder entfernt.

In den Figuren 7A bis 7C sind drei weitere Möglichkeiten der Ausgestaltung der Vorrichtung zur Extraktion von elektrischen Ladungsträgern schematisch dargestellt, bei denen die Ablagerung von Materialteilchen an den Innenseiten der Öffnungen der ersten Elektrode und/oder das Abplatzen von abgelagertem Material verringert oder vermieden wird.

Dazu weist die Vorrichtung (1b) zur Extraktion von Ladungsträgern, dargestellt in Fig. 7A, eine erste Elektrode (11b) auf, die zwar Öffnungen mit der üblichen räumlichen Form und den üblichen Abmessungen aufweist, die aber wesentlich dünner ausgebildet ist, als eine herkömmliche Elektrode, wie bspw. die Screenelektrode (10) und die Masseelektrode (12). Beispielsweise sind Elektroden aus Graphit, insbesondere Gitterelektroden, meist zwischen 1 und 3 mm dick. Elektroden aus Metall, bspw. aus Molybdän oder Wolfram, können dagegen wesentlich dünner, bspw. nur mit einer Dicke zwischen 180 und 200 $\mu$m, ausgebildet werden. Dadurch kann sich an den Innenseiten der Öffnungen (111b) der ersten Elektrode (11b) weniger rückgestreutes Material ablagern, so dass die Gefahr des Abplatzens dieser Ablagerungen und die Auswirkungen abgeplatzter Teilchen minimiert werden.

Eine andere Möglichkeit ist in Fig. 7B dargestellt. Dabei besteht die erste Elektrode (11c) der Vorrichtung (1c) zur Extraktion von Ladungsträgern aus einem Material, auf dem das von der Substratoberfläche zurückgestreute Material besser haftet als auf gewöhnlichem Elektrodenmaterial oder das mit dem von der Substratoberfläche zurückgestreuten Material chemisch reagiert. Üblicherweise werden die Elektroden einer Vorrichtung zur Extraktion von elektrischen Ladungsträgern aus einem Ladungsträgererzeugungsraum aus Graphit hergestellt, da dieses Material eine geringe Abtragsrate gegenüber einem physikalischen oder chemischen Angriff und damit eine hohe Standzeit aufweist. Jedoch haften die meisten Materialien, bspw. Silizium (Si), welches oftmals mit Ionenstrahlen bearbeitet wird, schlecht darauf, so dass es zu Abplatzungen und den dadurch begünstigten Bogenentladungen kommt. Wird jedoch die erste Elektrode (11c), die vor einem direkten physikalischen und chemischen Angriff durch die Screenelektrode (10) und die Masseelektrode (12) zumindest teilweise abgeschirmt ist, aus einem anderen Material, bspw. einem Metall wie Molybdän oder Wolfram, hergestellt, so haftet das rückgestreute Silizium besser darauf oder bildet sogar eine chemische Verbindung mit dem Material, welches ebenfalls weniger zu Abplatzungen neigt.

In dem Ausführungsbeispiel, welches in Fig. 7C dargestellt ist, weist die Vorrichtung (1d) zur Extraktion von Ladungsträgern eine erste Elektrode (1d) auf, die wie die anderen Elektroden (10, 12) aus Graphit besteht, jedoch zumindest an den Innenseiten der Öffnungen (111 d) eine Beschichtung mit einem anderen Material (117) aufweist. Auf diesem anderen Material (117), bspw. Molybdän oder Wolfram, haftet das von der Substratoberfläche zurückgestreute Material, z.B. Si, besser oder das andere Material (117) reagiert chemisch mit dem von der Substratoberfläche zurückgestreuten Material und bildet ein Material, das besser auf dem Graphitmaterial der ersten Elektrode (11 d) haftet. Vorzugsweise weisen dabei korrespondierende Öffnungen aller Elektroden (10, 11d, 12) die gleichen Öffnungsweiten auf.

In den mit Bezug auf die Fig. 7A bis 7C beschriebenen Fällen wird das Abplatzen von Material, das von der Substratoberfläche zurückgestreut wurde und sich an den Innenseiten der Öffnungen der ersten Elektrode (11b bis 11d) ablagert, verringert oder vermieden und damit das Entstehen von Bogenentladungen verhindert oder soweit hinausgezögert, dass die Anforderungen an die Standzeit der Vorrichtung (1b bis 1d) zur Extraktion von elektrischen Ladungsträgern erfüllt werden.

Mit Bezug auf Fig. 8 wird nachfolgend ein Verfahren beschrieben, das zur Verringerung von Ablagerungen an den Innenseiten der Öffnungen der ersten Elektrode oder zur Verringerung der negativen Auswirkungen solcher Ablagerungen dient. Dazu wird ein zusätzliches Gas in die Ionenstrahlquelle eingelassen, das das an den Innenseiten der Öffnungen in der ersten Elektrode abgelagerte Material chemisch reaktiv verändert. In der schematischen Darstellung in Fig. 8 ist die Vorrichtung (1e) zur Extraktion von elektrischen Ladungsträgern aus dem Ladungsträgererzeugungsraum (2) mit einer Screenelektrode (10), einer ersten Elektrode (11e) und einer Masseelektrode (12) u sehen. An den Innenseiten der Öffnungen (111e) der ersten Elektrode (11e) lagert sich Material (118) ab, das von der bearbeiteten Substratoberfläche zurückgestreut wurde. Ein zusätzliches Gas (5) wird in die Vorrichtung (1e) zur Extraktion der Ladungsträger eingespeist. Das zusätzliche Gas (5) ist ein Gas, das mit dem abgelagerten Material (118) reagiert und dabei entweder ein Gas oder eine chemische Verbindung, die besser als das ursprünglich abgelagerte Material (118) auf dem Material der ersten Elektrode (11e) haftet, bildet. Beispielsweise kann das zusätzliche Gas $N_2$ sein, das mit dem an den Innenseiten der Öffnungen (111e) der ersten Elektrode (11e) abgelagertem Silizium (Si) reagiert und festes Siliziumnitrid (SiN) bildet. Dieses Siliziumnitrid wiederum haftet besser als das rückgestreute Silizium auf dem Material der ersten Elektrode (11 e) und bildet gleichzeitig eine Oberfläche der ersten Elektrode (11e), auf der weiteres rückgestreutes Silizium besser haftet als auf dem ursprünglichen Elektrodenmaterial der ersten Elektrode (11 e). Wird durch die Reaktion des zusätzlichen Gases (5) mit dem abgelagerten Material (118) ein Gas gebildet, so kann dieses mit Hilfe von Pumpen abgesaugt werden. Beispielhaft wird als zusätzliches Gas ein fluorhaltiges Gas, z.B. $SF_6$, $CF_4$, $NF_3$ oder $CHF_3$, verwendet, das mit rückgestreutem und an den Innenseiten der Öffnungen (111e) der ersten Elektrode (11e) abgelagertem Silizium (Si) reagiert und gasförmiges Siliziumfluorid (SiF) bildet. Das zusätzliche Gas (5) kann bspw. in Form von Ionen vorliegen und gemeinsam mit den elektrischen Ladungsträgern zur Bearbeitung einer Substratoberfläche im Ladungsträgererzeugungsraum (2) erzeugt und durch die Vorrichtung (1e) zur Extraktion von Ladungsträgern aus dem Ladungsträgererzeugungsraum (2) extrahiert und dem abgelagerten Material (118) zugeführt werden. Jedoch kann das zusätzliche Gas (5) auch separat eingespeist werden. Das zusätzliche Gas (5) kann während des Bearbeitungsprozesses eines Substrates und/oder in den Pausen zwischen zwei Bearbeitungsprozessen eingespeist werden, so dass das abgelagerte Material (118) kontinuierlich oder von Zeit zu Zeit, d.h. zyklisch, entfernt oder chemisch reaktiv verändert wird.

Beispielhaft seien folgende Werte genannt: Bei einer zyklischen Einspeisung des zusätzlichen Gases (5) wird alternierend ein normaler Bearbeitungsprozess ohne das zusätzliche Gas (5) für eine Zeitdauer von 12 Stunden und ein Bearbeitungsprozess mit $SF_6$ als zusätzlichem Gas (5) mit 30 Volumen-% des Gesamtgasstroms in der Bearbeitungsanlage für 2 min ausgeführt. Damit liegt die Gaszugabe des zusätzlichen Gases (5) über die Gesamtdauer eines Zykluses im Promillebereich im Vergleich zum normalen Bearbeitungsgas, z.B. Ar.

Wird das zusätzliche Gas (5) während des Bearbeitungsprozesses eines Substrates zugeführt, so gelangt es auch an die Oberfläche des Substrates, wo es die Bearbeitung des Substrates ggf. unterstützt. So kann ein fluorhaltiges zusätzliches Gas (5) beim Ionenstrahlätzen von Silizium oder siliziumhaltigen Verbindungen, z.B. mittels Ar-Ionen, eine chemische Komponente zum Abtrag des Substratmaterials beitragen und damit die Ätzrate erhöhen. Darüber hinaus kann das zusätzliche Gas (5) auch die Menge der von der Substratoberfläche bis zur Vorrichtung (1e) zur Extraktion der Ladungsträger gelangenden Materialteilchen verringern, indem es bspw. mit den rückgestreuten Materialteilchen bereits vor Erreichen der Vorrichtung (1 e) reagiert.

Einige oder alle der genannten Möglichkeiten zur Verringerung oder Verhinderung von Bogenentladungen können auch miteinander kombiniert werden, solange sie sich nicht gegenseitig ausschließen.


**Bezugszeichen**


| | |
|---|---|
| 1, 1a-1d | Vorrichtung zur Extraktion von Ladungsträgern |
| 10 | Screenelektrode |
| 101 | Öffnung in Screenelektrode |
| 11, 11a-11d | Erste Elektrode |
| 111 | Öffnung in erster Elektrode |
| 112 | Erste Oberfläche der ersten Elektrode |
| 113 | Zweite Oberfläche der ersten Elektrode |
| 114 | Innenseite einer Öffnung |
| $114_1$ | Erste Innenseitenkurve |
| $114_2$ | Zweite Innenseitenkurve |
| 115 | Begrenzungslinie der Öffnung auf der ersten Oberfläche |
| 116 | Begrenzungslinie der Öffnung auf der zweiten Oberfläche |
| 117 | Beschichtungsmaterial an Innenseite der Öffnung |
| 118 | Ablagerung von rückgestreutem Material an Innenseite der Öffnung |
| 12 | Masseelektrode |
| 121 | Öffnung in Masseelektrode |
| 122 | Erste Oberfläche der Masseelektrode |
| 123 | Zweite Oberfläche der Masseelektrode |
| 2 | Ladungsträgererzeugungsraum |
| 3 | Teilchenstrahlquelle |
| 31 | Gehäuse |
| 4 | Substrat |
| 41 | Substratoberfläche |
| 411 | Bearbeiteter Oberflächenbereich |
| 5 | Zusätzliches Gas |
| $A_1$ | Erster Flächeninhalt |
| $A_2$ | Zweiter Flächeninhalt |
| $a_{11}$ | Abstand der ersten Oberfläche der ersten Elektrode von der Substratoberfläche |
| $a_{12}$ | Abstand der ersten Oberfläche der Masseelektrode von der Substratoberfläche |
| $a_{21}$ | Abstand der zweiten Oberfläche der Masseelektrode von der ersten Oberfläche der ersten Elektrode |
| $\alpha$ | Winkel zwischen der Verbindungslinie und der Mittelpunktnormalen |
| $\alpha_1$ | erster Winkel |
| $d_1$ | Erster Abstand |
| $d_2$ | Zweiter Abstand |
| $d_i$ | Abstand des Punktes Pi zur Mittelpunktnormalen |
| $d_j$ | Abstand des Punktes Pj zur Mittelpunktnormalen |
| $h_{11}$, $h_{11a}$ | Höhe der ersten Elektrode |
| $h_{12}$ | Höhe der Masseelektrode |

| M | Mittelpunkt der Öffnung an der ersten Oberfläche |
| m | Mittelpunktnormale |
| $P_1$ | Erster Punkt |
| $P_2$ | Zweiter Punkt |
| $P_3$ | Dritter Punkt |
| $P_4$ | Vierter Punkt |
| $P_i$ | Punkt auf der ersten Innenseitenkurve |
| $P_j$ | Punkt auf der zweiten Innenseitenkurve |
| v | Verbindungslinie des ersten und des dritten Punktes |
| $w_{10}$ | Öffnungsweite der Öffnung in der Screenelektrode |
| $w_{11a}$ | Öffnungsweite der Öffnung in der ersten Elektrode |
| $w_{12}$ | Öffnungsweite der Öffnung in der Masseelektrode |
| $w_o$ | Öffnungsweite der Öffnung in der ersten Elektrode an der ersten Oberfläche |
| $w_u$ | Öffnungsweite der Öffnung in der ersten Elektrode an der zweiten Oberfläche |

**Patentansprüche**

1. Vorrichtung zur Extraktion von elektrischen Ladungsträgern aus einem Ladungsträgererzeugungsraum mit einer ersten Elektrode, die mindestens eine Öffnung zum Durchtritt der elektrischen Ladungsträger enthält, mindestens in lateralen Bereichen angrenzend an die mindestens eine Öffnung elektrisch leitfähig und von allen Elektroden der Vorrichtung, die während des Betriebes der Vorrichtung der Beschleunigung von elektrischen Ladungsträgern aus dem Ladungsträgererzeugungsraum in Teilchenaustrittsrichtung dienen, diejenige Elektrode ist, die den geringsten Abstand zum Ladungsträgererzeugungsraum in Teilchenaustrittsrichtung aufweist, wobei die Öffnung in einer ersten Oberfläche der ersten Elektrode einen ersten Flächeninhalt hat, der kleiner ist als ein zweiter Flächeninhalt der Öffnung in einer zweiten Oberfläche der ersten Elektrode, wobei die erste Oberfläche die dem Ladungsträgererzeugungsraum abgewandte Oberfläche der ersten Elektrode und die zweite Oberfläche die dem Ladungsträgererzeugungsraum zugewandte Oberfläche der ersten Elektrode ist.

2. Vorrichtung nach Anspruch 1, **dadurch gekennzeichnet, dass** in jeder Querschnittsebene durch die Öffnung der ersten Elektrode ein erster Punkt auf der Begrenzungslinie der Öffnung auf der ersten Oberfläche der ersten Elektrode einen ersten Abstand zum Mittelpunkt der Öffnung in der ersten Oberfläche aufweist und alle anderen Punkte auf der mit dem ersten Punkt in der Querschnittsebene verbundenen ersten Innenseitenkurve der Öffnung einen Abstand zu der Mittelpunktnormalen aufweisen, der gleich oder größer als der erste Abstand ist, wobei mindestens ein Teil aller Punkte einen größeren Abstand aufweisen und wobei die Mittelpunktnormale die Normale auf die erste Oberfläche oder auf die Tangente an die erste Oberfläche im Mittelpunkt der Öffnung in der ersten Oberfläche ist.

3. Vorrichtung nach Anspruch 1 oder 2, **dadurch gekennzeichnet, dass** sich die Form der Öffnung in Ebenen, die senkrecht zur Teilchenaustrittsrichtung verlaufen, über die Ausdehnung der Öffnung von der ersten Oberfläche zur zweiten Oberfläche der ersten Elektrode nicht wesentlich ändert.

4. Vorrichtung nach Anspruch 2, **dadurch gekennzeichnet, dass** eine Verbindungslinie zwischen dem ersten Punkt der Öffnung und einem zweiten Punkt, der auf der Begrenzungslinie der Öffnung auf der zweiten Oberfläche der ersten Elektrode liegt, in der Querschnittsebene in einem Winkel von größer 0° zur Mittelpunktnormalen verläuft, wobei der zweite Punkt auf der mit dem ersten Punkt verbundenen Innenseitenkurve liegt.

5. Vorrichtung nach Anspruch 4, **dadurch gekennzeichnet, dass** der Winkel im Bereich von 1° bis 35° liegt.

6. Vorrichtung nach Anspruch 4 oder 5, **dadurch gekennzeichnet, dass** mindestens eine Innenseitenkurve der Öffnung der ersten Elektrode in der Querschnittsebene die dazugehörige Verbindungslinie maximal berührt, jedoch nicht schneidet.

7. Vorrichtung nach Anspruch 6, **dadurch gekennzeichnet, dass** jede Innenseitenkurve der Öffnung in jeder Querschnittsebene die dazugehörige Verbindungslinie maximal berührt, jedoch nicht schneidet.

8. Vorrichtung nach Anspruch 2, **dadurch gekennzeichnet, dass** der Abstand der Punkte mindestens einer Innenseitenkurve von der Mittelpunktnormalen zwischen der ersten Oberfläche der ersten Elektrode und der zweiten Oberfläche der ersten Elektrode zunimmt.

9. Vorrichtung nach Anspruch 8, **dadurch gekennzeichnet, dass** der Abstand der Punkte von der Mittelpunktnormalen stetig zunimmt.

10. Vorrichtung nach Anspruch 9, **dadurch gekennzeichnet, dass** mindestens eine Innenseitenkurve der Öffnung der ersten Elektrode geradlinig zwischen der ersten und der zweiten Oberfläche der ersten Elektrode verläuft.

11. Vorrichtung nach einem der vorhergehenden Ansprüche, **dadurch gekennzeichnet, dass** die erste Elektrode eine Vielzahl von Öffnungen zum Durchtritt von Ladungsträgern aufweist und dass alle Öffnungen entsprechend Anspruch 1 ausgebildet sind.

Fig. 1

Fig. 2

Fig. 3A

Fig. 3B

Fig. 4A

Fig. 4B

Fig. 5

Fig. 6

111b

2

10

11b

1b

12

Fig. 7A

111c

10

11c

1c

12

Fig. 7B

Fig. 7C

Fig. 8

**Europäisches Patentamt**
**European Patent Office**
**Office européen des brevets**

# EUROPÄISCHER RECHERCHENBERICHT

Nummer der Anmeldung

EP 16 19 7531

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP 2000 273630 A (JAPAN AVIATION ELECTRON) 3. Oktober 2000 (2000-10-03) * Zusammenfassung; Abbildungen 1-4 * * Absätze [0009], [0010], [0012] - [0015], [0020], [0021] * ----- | 1-4,6-8, 11 | INV. H01J37/305 H01J37/04 H01J37/08 |
| X | FR 1 513 576 A (THOMSON HOUSTON COMP FRANCAISE) 16. Februar 1968 (1968-02-16) * Seiten 2,3; Abbildung 1 * ----- | 1-10 | |
| X | US 2007/080647 A1 (DESIERES YOHAN [FR] ET AL) 12. April 2007 (2007-04-12) * Abbildungen 4,8B * * Absätze [0060], [0073] - [0077], [0087], [0133] - [0138] * ----- | 1-11 | |

RECHERCHIERTE SACHGEBIETE (IPC)

H01J

Der vorliegende Recherchenbericht wurde für alle Patentansprüche erstellt

| Recherchenort | Abschlußdatum der Recherche | Prüfer |
|---|---|---|
| München | 10. Mai 2017 | Giovanardi, Chiara |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 16 19 7531

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-05-2017

| Im Recherchenbericht angeführtes Patentdokument | Datum der Veröffentlichung | Mitglied(er) der Patentfamilie | Datum der Veröffentlichung |
|---|---|---|---|
| JP 2000273630 A | 03-10-2000 | JP 4175723 B2<br>JP 2000273630 A | 05-11-2008<br>03-10-2000 |
| FR 1513576 A | 16-02-1968 | KEINE | |
| US 2007080647 A1 | 12-04-2007 | EP 1702345 A2<br>JP 2007518223 A<br>US 2007080647 A1<br>WO 2005074001 A2 | 20-09-2006<br>05-07-2007<br>12-04-2007<br>11-08-2005 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4523971 A
- DE 102004002508 A1
- US 7285788 B2